Europäisches Patentamt

European Patent Office

Office européen des brevets

(19)

(11) Veröffentlichungsnummer: **0 087 627**
**A1**

(12) **EUROPÄISCHE PATENTANMELDUNG**

(21) Anmeldenummer: 83101223.2

(22) Anmeldetag: 09.02.83

(51) Int. Cl.³: **H 03 J 1/06**
**H 01 C 10/40**

(30) Priorität: 12.02.82 DE 8203905 U

(43) Veröffentlichungstag der Anmeldung:
07.09.83 Patentblatt 83/36

(84) Benannte Vertragsstaaten:
AT BE CH FR GB IT LI NL SE

(71) Anmelder: PREH, Elektrofeinmechanische Werke Jakob
Preh Nachf. GmbH & Co.
Postfach 1740 Schweinfurter Strasse 5
D-8740 Bad Neustadt/Saale(DE)

(72) Erfinder: Schulz, Georg
Zeilweg 3
D-8741 Leutershausen/Hohenroth(DE)

(72) Erfinder: Wilz, Norbert
Wiesenstrasse 6
D-8740 Bad Neustadt/Saale(DE)

(54) Widerstandsbaueinheit für Einstellaggregate.

(57) Die Einheit wird in Rundfunk- und Fernsehgeräte, mit Kapazitätsdiodenabstimmung verwendet. Die Steuerspannung für die Kapazitätsdioden wird von mehreren, nebeneinander angeordneten Spindelwiderständen abgenommen, bei denen jeweils ein Schleifer (6) entlang einer in einem Gehäuse drehbar gelagerten Spindel (5) auf einer aus einer homogenen Widerstandsschicht bestehenden Widerstandsfläche entlanggleitet. Alle Widerstandsflächen sind nun gemeinsam auf einem Substrat (1) parallel nebeneinander angeordnet, wobei sie untereinander durch gut leitende Anfangs- und Enschienen (2,3) elektrisch miteinander verbunden sind. Um die Temperaturdrift auf ein Minimum zu reduzieren, wird vorgeschlagen, eine für alle Spindelwiderstände gemeinsame, großflächige Widerstandsfläche (4) zu verwenden.

Fig. 1

P r e h
Elektrofeinmechanische Werke
Jakob Preh Nachf. GmbH & Co.
Schweinfurter Straße 5
8740 Bad Neustadt / Saale

**0087627**

, den 09.02.1982

3/82 GM
Bsch/Hi

## Widerstandsbaueinheit für Einstellaggregate

Die Neuerung geht von einer Widerstandsbaueinheit für Einstellaggregate nach dem Oberbegriff des Anspruches 1 aus.

Derartige Einstellaggregate werden in verschiedenen Ausführungsformen bevorzugt bei der Abstimmung und Einschaltung von Rundfunk- und Fernsehgeräten eingesetzt. Durch einen einzigen Tastendruck kann jeweils die voreingestellte Abstimmspannung und damit die zugeordnete Station bzw. der Kanal eingeschaltet werden. Die Speicherung der eingestellten Abstimmspannung erfolgt in Kanalspeichern in der Form von als Spannungsteiler geschalteten Spindelwiderständen. Als frequenzbestimmende Abstimmorgane verwendet man Kapazitätsdioden. Bei der Kapazitätsdiode handelt es sich um einen Halbleiter, dessen Sperrschichtkapazität in definierter Weise von der angelegten Spannung abhängig ist. Sie bietet daher eine günstige Möglichkeit, Schwingkreise durch Spannungsänderungen abzustimmen, die in einfachster Weise durch als Spannungsteiler geschaltete, ohmsche Widerstände erzeugt werden können.

Die Verwendung einer derartigen Kapazitätsdioden-Abstimmung zur Festsender-Abstimmung ist an sich bekannt. So ist in der DE-AS 1 171 032 der Hinweis gegeben, für Zwecke der UKW-Rundfunk- bzw. Fernsehempfänger-Abstimmung eine diskontinuierliche Festsender-Abstimmung mit einstellbaren und wahlweise einstellbaren Betriebsspannungen für Kapazitätsdioden vorzusehen, wobei die Erzeugung der Vorspannungen wahlweise mittels eines Spannungsteilers oder mittels fest eingestellten Einzelpotentiometern erfolgen soll und die Aufschaltung der diskreten, der Abstimmung auf die gewünschten Sender bzw. Kanäle entsprechenden Vorspannungen auf die Abstimmkapazitätsdiode mittels sich gegenseitig auslösenden Drucktastenschaltern erfolgen kann.

Da einerseits die Kapazitätsdioden einen nichtlinearen Verlauf haben, aber andererseits die Anzeigeskala möglichst linear sein soll, sollte auch der Spannungsverlauf der Spindelwiderstände in kompensierendem Sinne nichtlinear sein. Aus der DE-PS 1 540 265 ist bereits eine Widerstandsbaueinheit für Einstellaggregate bekannt, bei der auf einer rechteckigen Hartpapierplatte am oberen und unteren Rand eine Anfangs- und Endschiene aus gut leitendem Material aufgebracht ist. Zwischen diesen beiden Schienen befinden sich mehrere Widerstandsflächen aus einem homogenen Widerstandsmaterial. Das zur Schleiferbahn senkrechte Breitenmaß der einzelnen Widerstandsflächen nimmt nach einer vorgegebenen Funktion zu oder ab. Hierzu verlaufen die seitlichen Begrenzungslinien in Form von Exponentialkurven derart, daß die Breite der Schichtfläche an der Anfangsschiene mehrfach größer ist als die an der Endschiene. Damit ist im letzten Drittel der Kurve bis zur Endschiene eine größere Stromdichte und damit größere thermische Belastung bedingt durch die geringere Breite gegeben. Eine höhere thermische Belastung wiederum hat für Schleiferstellungen in diesem Kurvenabschnitt eine größere Temperaturdrift der eingestellten Spannung zur Folge. Abhängig von der angelegten Spannung liegt die Temperaturdrift in der Größenordnung von 0,5 mV/°C bis 1,5 mV/°C.

Aufgabe der vorliegenden Neuerung ist es, eine Widerstandsbaueinheit für Einstellaggregate nach der eingangs genannten Art zu schaffen, die einfach und kostensparend herzustellen ist und bei der die Temperaturdrift auf ein Minimum reduziert ist.

Diese Aufgabe wird neuerungsgemäß durch die im kennzeichnenden Teil des Anspruches 1 angegebenen Merkmale gelöst.

Versuche haben ergeben, daß bei einer für alle Spindelpotentiometer gemeinsamen, einzigen, großflächigen Widerstandsfläche der geringste Temperaturdrift vorhanden ist und zwar über die gesamte Abstimmlänge hinweg. Die Widerstandsbaueinheit gemäß der Neuerung liefert eine lineare Abhängigkeit der Abstimmspannung, demzufolge wird sie bevorzugt dort eingesetzt, wo es nicht so sehr auf eine Anzeigeskalenlinearität, sondern auf eine möglichst geringe Temperaturdrift ankommt.

0087627

Die Neuerung wird nachfolgend für ein Beispiel anhand der Zeichnung näher erläutert.

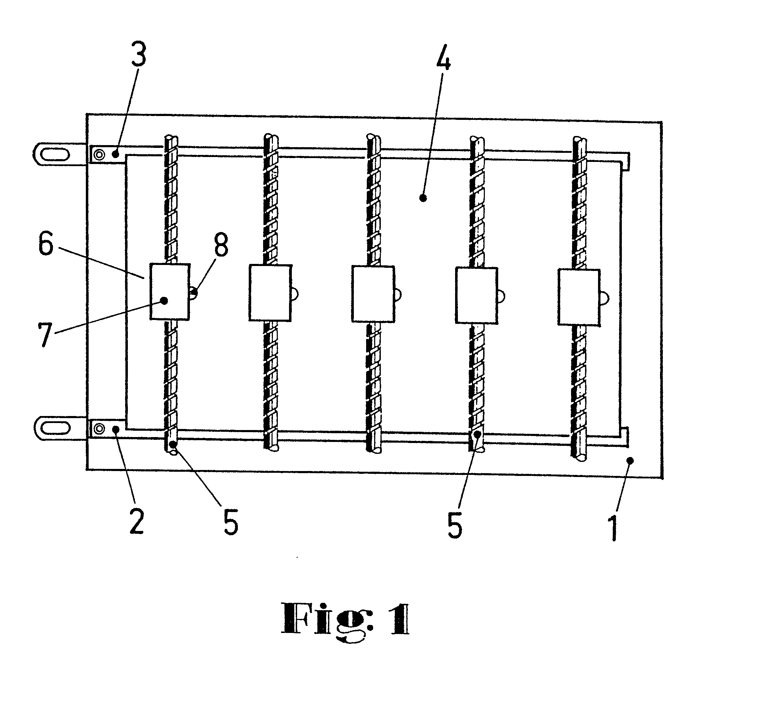

Figur 1 zeigt die Draufsicht auf eine Widerstandsbaueinheit

In Figur 1 ist ein Ausführungsbeispiel der Widerstandsbaueinheit dargestellt. Mit 1 ist ein rechteckiges Substrat bezeichnet, das aus einem Isolierstoff hergestellt ist. Dieser Isolierstoff kann Hartpapier, Epoxydharz oder ein hochtemperaturbeständiger Kunststoff, wie z.B. Polyphenylenoxyd, Polyphenylensulfid, Polyimid oder Polyäthersulfat, sein. Auf das Substrat 1 sind auf den oberen und den unteren Rand mittels Spritzen mit Schablonen, mittels Siebdruck oder mittels eines ähnlichen bekannten Verfahrens eine Anfangsschiene 2 und eine Endschiene 3 aus einem elektrisch gut leitendem Material, wie z.B. Leitsilber, aufgebracht. Zwischen diesen Schienen befindet sich eine Widerstandsfläche 4, die ebenfalls mittels Siebdruck, mittels Schablonenspritzen oder mittels eines ähnlichen Verfahrens aufgebracht und anschließend ausgehärtet ist. Die Widerstandsfläche 4 besteht aus einem homogenen Widerstandsmaterial und sie bedeckt nahezu die ganze Oberfläche des Substrates.

Die Widerstandsbaueinheit ist Teil eines Einstellaggregates, von dem in Figur 1 nur die Spindeln 5 mit den Schleifern 6 dargestellt sind, die auf den Spindeln entlanggleiten können. Jeder Schleifer 6 besteht aus einem Federträger 7 und einer Schleifkontaktfeder 8, die auf der Widerstandsschicht federnd aufliegt. Durch Drehen der Spindel mit Hilfe eines nicht dargestelltes Knopfes kann der Schleifer bewegt werden und so die abgegriffene Abstimmspannung verändert werden.

Bezugszeichen zu 3/82                                    0087627

1  Substrat

2  Anfangsschiene

3  Endschiene

4  Widerstandsfläche

5  Spindel

6  Schleifer

7  Federträger

8  Schleifkontaktfeder

0087627

P r e h
Elektrofeinmechanische Werke
Jakob Preh Nachf. GmbH & Co.
Schweinfurter Straße 5
8740 Bad Neustadt / Saale

, den 09.02.1982

3/82 GM
Bsch/Hi

Widerstandsbaueinheit für Einstellaggregate

1. Widerstandsbaueinheit für Einstellaggregate für Rundfunk- und Fernsehgeräte mit Kapazitätsdiodenabstimmung, wobei die Steuerspannung für die Kapazitätsdioden von jeweils einem von mehreren, nebeneinander angeordneten Spindelpotentiometern abgenommen wird, bei denen jeweils ein Schleifer entlang einer in einem Rahmen drehbar gelagerten Spindel auf einer aus einer homogenen Widerstandsschicht bestehenden Widerstandsfläche entlanggleitet, und wobei alle Widerstandsflächen gemeinsam auf einem Substrat parallel nebeneinander, zwischen einer allen Widerstandsflächen gemeinsamen, gut leitenden Anfangs- und Endschiene angeordnet sind,
dadurch gekennzeichnet,
daß das zur Schleiferbahn senkrechte Breitenmaß der Widerstandsflächen über die ganze Abstimmlänge gleich ist und mindestens zwei unmittelbar nebeneinanderliegende Widerstandsflächen sich über den gesamten Abstand von der Anfangs- (2) bis zur Endschiene (3) kontaktierend berühren, so daß eine für alle Spindelpotentiometer gemeinsame, großflächige Widerstandsfläche (4) entsteht.

**Fig. 1**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-3 601 703 (E.L. MIDGLEY) <br> * Figuren 3, 4, 6; Spalte 4, Zeile 70 - Spalte 5, Zeile 27 * <br> --- | 1 | H 03 J 1/06 <br> H 01 C 10/40 |
| A | US-A-3 522 542 (W. LABUDE et al.) <br> * Spalte 3, Zeilen 47-52 * <br> --- | | |
| A | DE-A-1 690 342 (TELEFUNKEN) <br><br> * Figur 1, Position 5; Seite 2, Zeilen 11-14 * <br> --- | | |
| A | DE-B-1 466 519 (TELEFUNKEN) <br><br> * Figur 3, Position 30; Spalte 4, Zeilen 63-68 * <br> ----- | | RECHERCHIERTE SACHGEBIETE (Int. Cl. ³) <br><br> H 03 J 1/06 <br> H 03 J 3/18 <br> H 01 C 10/16 <br> H 01 C 10/40 |

Der vorliegende Recherchenbericht wurde für alle Patentansprüche erstellt.

| Recherchenort <br> BERLIN | Abschlußdatum der Recherche <br> 06-05-1983 | Prüfer <br> BREUSING J |
|---|---|---|